# EUROPÄISCHE PATENTSCHRIFT

(11) **EP 0 926 827 B1**
(45) Veröffentlichungstag und Bekanntmachung des Hinweises auf die Patenterteilung: **21.07.2004**
(21) Anmeldenummer: 98118502.8
(22) Anmeldetag: 30.09.1998
(51) Int. Cl.: H03K 19/003

(54) **Integrierte Halbleiterschaltung mit wenigstens zwei Versorgungsnetzen**
Integrated circuit with at least two power supply voltages
Circuit intégré avec au moins deux tensions d'alimentation

(30) Priorität: 20.11.1997 DE 19751540
(43) Veröffentlichungstag der Anmeldung: 30.06.1999
(73) Patentinhaber: Infineon Technologies AG, 81669 München (DE)
(72) Erfinder: Buck, Martin, 81243 München (DE)
(74) Vertreter: Müller - Hoffmann & Partner

(56) Entgegenhaltungen:
- PATENT ABSTRACTS OF JAPAN vol. 098, no. 011, 30. September 1998 & JP 10 163847 A (ADVANTEST CORP), 19. Juni 1998
- PATENT ABSTRACTS OF JAPAN vol. 016, no. 354 (E-1242), 30. Juli 1992 & JP 04 111350 A (TOSHIBA CORP), 13. April 1992
- PATENT ABSTRACTS OF JAPAN vol. 017, no. 418 (E-1408), 4. August 1993 & JP 05 083108 A (NEC IC MICROCOMPUT SYST LTD), 2. April 1993
- PATENT ABSTRACTS OF JAPAN vol. 095, no. 001, 28. Februar 1995 & JP 06 291634 A (NEC IC MICROCOMPUT SYST LTD), 18. Oktober 1994

## Beschreibung

Die Erfindung betrifft eine integrierte Halbleiterschaltung mit wenigstens zwei unabhängig voneinander gespeisten Versorgungsnetzen, nämlich einem ersten, einem Lastkreis zugeordneten Last-Versorgungsnetz und einem zweiten, einem Treiberschaltkreis zugeordneten Treiber-Versorgungsnetz, wobei jedes Versorgungsnetz jeweils separat einen Massezweig mit Masseleitungen und einen Versorgungszweig mit Versorgungspotentialleitungen besitzt und wobei eine Ausgleichsschaltung vorgesehen ist, die die Massezweige und/oder die Versorgungszweige der wenigstens zwei Versorgungsnetze wahlweise miteinander elektrisch koppelt.

Eine solche integrierte Halbleiterschaltung ist aus Patent Abstracts of Japan, Vol. 016, Nr. 354 (E-1242), 30. Juli 1992 & JP 04111350 A (D1) bekannt. Bei dieser Halbleiterschaltung handelt es sich um eine rauscharme Halbleitervorrichtung. Auf die monolithische Integration von DRAM- oder SDRAM-Bausteinen wird nicht eingegangen.

Immer höhere Taktfrequenzen bei digitalen Halbleiterbausteinen wie beispielsweise DRAM-Speicherbausteinen zwingen die im Halbleiterchip vorgesehenen Ausgangstreiber zu immer kürzeren Schaltzeiten. Diese sehr kurzen Schaltzeiten verursachen Stromspitzen während der Schaltzeit, welche wiederum Spannungsschwankungen in den Versorgungsnetzen des Halbleiterchips und damit Rauschen verursachen, welche die ordnungsgemäße Funktion der auf dem Halbleiterchip ausgebildeten digitalen Schaltkreise beeinträchtigen können. Zur Behebung dieser Mängel wurde versucht, die auf dem Halbleiterchip vorgesehenen digitalen Schaltkreise möglichst unempfindlich gegen Rauschprozesse zu entwickeln, was jedoch nicht ohne Geschwindigkeitsverluste einherging. Des Weiteren wurde der Versuch unternommen, für die Versorgung der Ausgangstreiberschaltungen (OCD = Off Chip Driver) gesonderte Versorgungspins vorzusehen, die allerdings eine separate Spannungsversorgung und damit erhöhten Schaltungsbedarf erfordern.

Der Erfindung liegt die Aufgabe zugrunde, eine integrierte Halbleiterschaltung der gattungsgemäßen Art, insbesondere eine Halbleiter-DRAM- oder -SDRAM-Schaltung mit auf dem Chip separat versorgten Treiberschaltkreisen zur Verfügung zu stellen, bei der das Rauschen aufgrund von Stromspitzen beim Schalten der Treiberschaltkreise auch ohne Geschwindigkeitsverluste erheblich verringert werden kann.

Diese Aufgabe wird durch eine integrierte Halbleiterschaltung gemäß Anspruch 1 gelöst.

Dem Prinzip der Erfindung folgend ist eine Ausgleichsschaltung vorgesehen, die die Massezweige und/oder die Versorgungszweige der wenigstens zwei Versorgungsnetze wahlweise miteinander elektrisch koppelt. Zweckmäßigerweise besitzt die Ausgleichsschaltung einen Logikschaltkreis, der die Belastung eines der wenigstens zwei Versorgungsnetze mit einem vorbestimmten Logikwert (logische EINS oder logische NULL) erfasst und als Reaktion hierauf ein gleichfalls in der Ausgleichsschaltung vorgesehenes Koppelelement im Sinne einer elektrischen Verbindung der Massezweige und/oder der Versorgungszweige der wenigstens zwei Versorgungsnetze steuert.

Wird von dem auf dem Halbleiterchip angeordneten Lastkreis eine logische EINS gelesen, so wird hierbei das positive Versorgungspotential der Treiberschaltkreise belastet. Wird eine logische NULL gelesen, so wird das Massepotential der Treiberschaltkreise belastet. Bei der erfindungsgemäßen Halbleiterschaltung wird nun während des Lesens einer logischen EINS das Massepotential des Last-Versorgungsnetzes (Massepotential der eigentlichen Logikschaltkreise) mit dem Massepotential des Treiber-Versorgungsnetzes (Massepotential der Treiberschaltkreise) verbunden und auf diese Weise stabilisiert. Beim Lesen einer logischen NULL wird entsprechend das positive Versorgungspotential des Last-Versorgungsnetzes mit dem positiven Versorgungspotential des Treiber-Versorgungsnetzes verbunden. Durch dieses wahlweise Verbinden der verschiedenen Versorgungsleitungen kann das Rauschen auf den Versorgungsleitungen für die Lastkreise erheblich verringert werden.

Bei einer schaltungsmäßig bevorzugten Ausführung der Erfindung ist das Koppelelement durch einen in der Halbleiterschaltung monolithisch integriert ausgebildeten Schalttransistor gebildet.

Die erfindungsgemäße Halbleiterschaltung mit der Ausgleichsschaltung eignet sich insbesondere für digitale Halbleiterschaltungen mit hohen Taktfrequenzen, beispielsweise digitalen DRAM-Speicherbauelementen oder SDRAM-Halbleiterbauelementen.

Die Erfindung ist in der nachfolgenden Beschreibung anhand zweier in der Zeichnung dargestellter Ausführungsbeispiele im Einzelnen beschrieben. In der Zeichnung zeigt:
- Figur 1: ein schematisches Schaltbild einer Ausgleichsschaltung zur Kopplung der Massezweige VSS und VSSQ;
- Figur 2: ein schematisches Schaltbild einer weiteren Ausgleichsschaltung zur Kopplung der Massezweige VSS und VSSQ und Versorgungszweige VDD und VDDQ; und
- Figur 3: Kurvendiagramme von gemessenen Spannungsverläufen zur Erläuterung der vorteilhaften Wirkungen der erfindungsgemäßen Schaltung nach Figur 2.

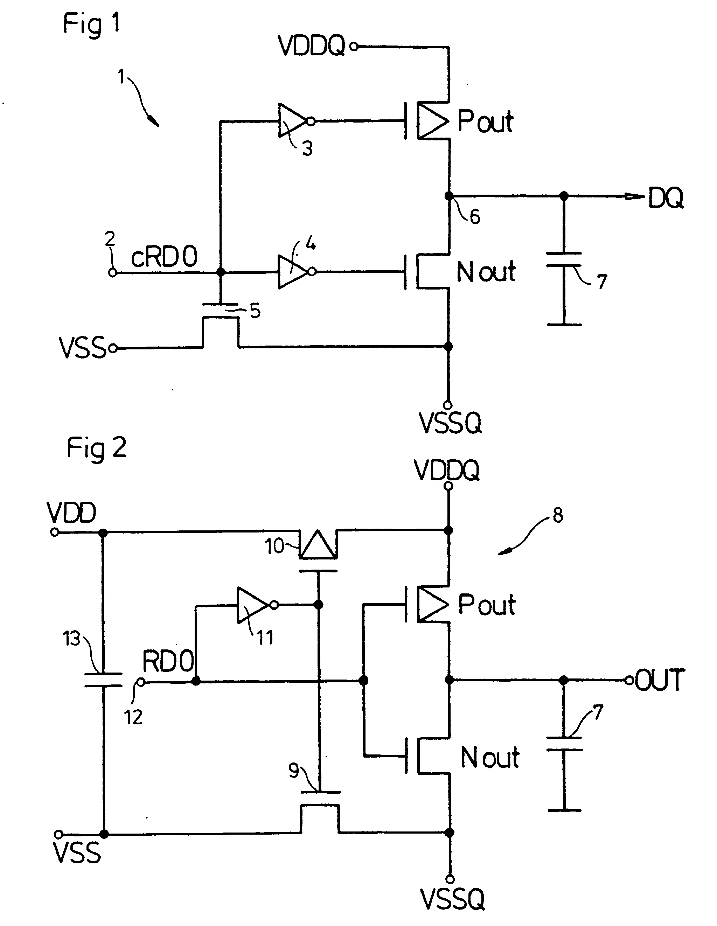

Das in Figur 1 dargestellte erste Ausführungsbeispiel der Erfindung umfasst eine Ausgleichsschaltung 1 zum wechselweise Verbinden des Massezweiges VSS eines ersten Versorgungsnetzes für die Lastkreise (digitale Logikschaltkreise, die auf dem Halbleiterchip ausgebildet sind, in den Figuren jedoch nicht dargestellt sind) mit dem Massezweig VSSQ eines zweiten Versorgungsnetzes für Treiberschaltkreise (insbesondere für Ausgangstreiber, die in den Figuren ebenfalls nicht dargestellt sind). Die Ausgleichsschaltung 1 besitzt einen Logikschaltkreis mit den beiden Inverterstufen 3, 4, dessen Eingang 2 die Belastung des Versorgungsnetzes mit einem Potentialwert entsprechend logisch EINS oder logisch NULL erfasst und als Reaktion hierauf ein Koppelelement 5 im Sinne der elektrischen Verbindung der Massezweige VSS und VSSQ steuert. Der Schalttransistor 5 stellt in dieser Ausführung einen n-Kanal-Feldeffekttransistor dar. Im dargestellten Beispiel ist der Eingang 2 beispielsweise mit der komplementären Leitung cRD0 eines Halbleiterspeichers verbunden. Ein p-Kanal-Feldeffekttransistor Pout und ein n-Kanal-Feldeffekttransistor Nout sind in Serie zwischen VDDQ (Versorgungszweig des zweiten Versorgungsnetzes) und VSSQ verbunden, wobei an dem Ausgangsknoten 6 die schematisch als Kapazität 7 dargestellten Lastkreise verbunden sind.

Die Funktionsweise der Ausgleichsschaltung 1 ist wie folgt. Wenn am Eingang 2 ein Pegelwert logisch EINS erfasst wird, beispielsweise als Folge eines Lesevorganges einer logischen EINS aus der Speicherzelle einer auf dem Halbleiterchip angeordneten Speicherschaltung, öffnet der Transistor Pout und verbindet den Ausgang DQ mit dem Versorgungszweig VDDQ. Das VDDQ-Netz wird somit belastet und schwankt deshalb. Der Massezweig VSSQ bleibt in diesem Fall stabil, so dass der Massezweig VSS mit dem Massezweig VSSQ stabilisiert werden kann. Zu diesem Zweck öffnet der Schalttransistor 5 und verbundet VSS mit VSSQ. Liegt am Eingang 2 hingegen der logische Pegelwert NULL an, etwa infolge des Auslesens einer logischen NULL aus der Speicherzelle, so schwankt der Massezweig VSSQ stark; da der Schalttransistor 5 diesmal sperrt, die Zweige VSS und VSSQ somit getrennt werden, werden die Schwankungen des Massezweiges VSSQ nicht auf den Zweig VSS übertragen.

Figur 2 zeigt ein vereinfachtes Schaltbild eines weiteren Ausführungsbeispieles der Erfindung mit einer Ausgleichsschaltung 8 für die wahlweise Kopplung der Zweige von beiden Versorgungsnetzen VSS und VDD. Dementsprechend sind zwei Koppelelemente in Form des n-Kanal-Feldeffekttransistors 9 und des p-Kanal-Feldeffekttransistors 10 vorgesehen, deren Gateanschlüsse über einen Inverter 11 mit dem Eingang 12 verbunden sind. Der Eingang 12 ist beispielsweise mit der Leitung RD0 des Speicherbauelementes verbunden (demgegenüber ist bei der Ausführung nach Figur 1 die komplementäre Leitung cRD0 betroffen, d.h. hier sind die entsprechend komplementären Logikwerte zu beachten). Pout bezeichnet wiederum einen p-Kanal-Feldeffekttransistor, Nout einen n-Kanal-Feldeffekttransistor, OUT den Ausgang der Schaltung 8; 7 schematisch die Lastkreise in Form einer Kapazität. Die Bezugsziffer 13 bezeichnet eine Dämpfungskapazität zwischen den Zweigen VSS und VDD, die den weiteren Vorteil einer Stabilisierung der Zweige VSS und VDD untereinander ermöglicht. Die Funktionsweise ist wie folgt. Falls am Eingang 12 ein logischer Pegelwert EINS erfasst wird, etwa als Folge eines Lesevorganges einer logischen NULL aus der Speicherzelle der auf dem Halbleiterchip angeordneten Speicherschaltung, schließt der Transistor 9, der Transistor 10 öffnet. Der Zweig VDD ist mit VDDQ gekoppelt, am Ausgang OUT wird das Netz VSSQ belastet. Liegt im anderen Fall am Eingang 12 eine logische NULL, etwa im Falle des Lesevorganges einer logischen EINS aus der Speicherzelle, öffnet der Transistor 9, der Transistor 10 ist geschlossen: Der Zweig VSS ist mit dem Zweig VSSQ gekoppelt, der Ausgang OUT belastet das Netz VDDQ.

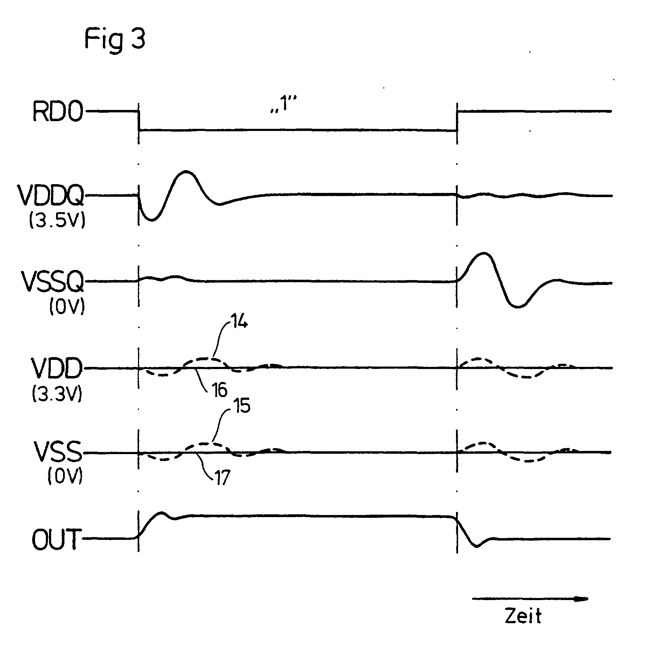

Figur 3 zeigt schematisch die zeitlichen Spannungsverläufe der Schaltung nach Figur 2 beim Lesen einer logischen EINS aus der Speicherzelle. Das Signal RD0 am Eingang 12 geht in diesem Fall auf den Wert logisch NULL, das Netz VDDQ wird belastet und schwankt, während das Netz VSSQ vergleichsweise stabil bleibt. Ohne die erfindungsgemäße Maßnahme würden die Spannungsverläufe auf den Zweigen VDD und VSS gemäß den Kurven 14 und 15 verlaufen, wobei die Amplitude der Schwankungen etwa 300 bis 400 mV beträgt, mit der erfindungsgemäßen Schaltungsmaßnahme werden die Schwankungen etwa um einen Faktor 2 verringert (Kurven 16 und 17).

## Patentansprüche

1. Integrierte Halbleiterschaltung mit wenigstens zwei unabhängig voneinander gespeisten Versorgungsnetzen, nämlich einem ersten, einem Lastkreis zugeordneten Last-Versorgungsnetz und einem zweiten, einem Treiberschaltkreis zugeordneten Treiber-Versorgungsnetz, wobei jedes Versorgungsnetz jeweils separat einen Massezweig (VSS, VSSQ) mit Masseleitungen und einen Versorgungszweig (VDD, VDDQ) mit Versorgungspotentialleitungen besitzt, und wobei eine Ausgleichsschaltung (1) vorgesehen ist, die die Massezweige (VSS, VSSQ) und/oder die Versorgungszweige (VDD, VDDQ) der wenigstens zwei Versorgungsnetze wahlweise miteinander elektrisch koppelt,
**dadurch gekennzeichnet,**
**dass** die Versorgungszweige (VDD, VDDQ) und entsprechend die Massezweige (VSS, VSSQ) der Versorgungsnetze im Betrieb der Halbleiterschaltung dasselbe Potential führen.

2. Halbleiterschaltung nach Anspruch 1,
**dadurch gekennzeichnet,**
**dass** die Ausgleichsschaltung (1) einen Logikschaltkreis aufweist, der die Belastung eines der wenigstens zwei Versorgungsnetze mit einem vorbestimmten Logikwert (logische EINS oder logische NULL) erfasst und als Reaktion hierauf ein gleichfalls in der Ausgleichsschaltung (1) vorgesehenes Koppelelement (5) im Sinne einer elektrischen Verbindung der Massezweige (VSS, VSSQ) und/oder der Versorgungszweige (VDD, VDDQ) der wenigstens zwei Versorgungsnetze steuert.

3. Halbleiterschaltung nach Anspruch 2,
**dadurch gekennzeichnet,**
**dass** das Koppelelement (5) durch einen ider Halbleiterschaltung monolithisch integriert ausgebildeten Schalttransistor gebildet ist.

## Claims

1. Integrated semiconductor circuit having at least two supply networks which are powered independently of one another, namely a first, load supply network, which is associated with a load circuit, and a second, driver supply network, which is associated with a driver circuit, each supply network having an earth path (VSS, VSSQ) with earth lines and a supply path (VDD, VDDQ) with supply potential lines, said paths being separate in each case, and a compensating circuit (1) being provided which alternatively the earth paths (VSS, VSSQ) and/or the supply paths (VDD, VDDQ) of the at least two supply networks to one another electrically, **characterized in that** the supply paths (VDD, VDDQ) and accordingly the earth paths (VSS, VSSQ) of the supply networks carry the same potential when the semiconductor circuit is in operation.

2. Semiconductor circuit according to Claim 1, **characterized in that** the compensating circuit (1) has a logic circuit which detects the load on one of the at least two supply networks in the form of a predetermined logic value (logic ONE or logic ZERO) and, in response to this, controls a coupling element (5), which is likewise provided in the compensating circuit (1), so as to make an electrical connection between the earth paths (VSS, VSSQ) and/or the supply paths (VDD, VDDQ) of the at least two supply networks.

3. Semiconductor circuit according to Claim 2, **characterized in that** the coupling element (5) is a switching transistor which is monolithically integrated in the semiconductor circuit.

## Revendications

1. Circuit intégré à semi-conducteurs ayant au moins deux réseaux d'alimentation alimentés indépendamment l'un de l'autre, à savoir un premier réseau d'alimentation de charge associé à un circuit de charge et un deuxième réseau d'alimentation d'attaque associé à un circuit d'attaque, chaque réseau d'alimentation ayant respectivement séparément une branche (VSS, VSSQ) de masse à conducteur de masse et une branche (VDD, VDDQ) d'alimentation à conducteur de potentiel d'alimentation et il est prévu un circuit (1) de compensation, qui relie électriquement entre elles au choix les branches (VSS, VSSQ) de masse et / ou les branches (VDD, VDDQ) d'alimentation des au moins deux réseaux d'alimentation,
**caractérisé**
**en ce que** les branches (VDD, VDDQ) d'alimentation et d'une manière correspondante les branches (VSS, VSSQ) de masse des réseaux d'alimentation appliquent en fonctionnement du circuit à semi-conducteur le même potentiel,

2. Circuit à semi-conducteurs suivant la revendication 1,
**caractérisé**
**en ce que** le circuit (1) de compensation comporte un circuit de commutation logique, qui détecte la charge de l'un des au moins deux réseaux d'alimentation par une valeur logique déterminée à l'avance (logique un ou logique zéro) et, en réaction à cela, commande un élément (5) de couplage prévu également dans le circuit (1) de compensation, dans le sens d'une liaison électrique des branches (VSS, VSSQ) de masse et / ou les branches (VDD, VDDQ) d'alimentation des au moins deux réseaux d'alimentation,

3. Circuit à semi-conducteurs suivant la revendication 2,
**caractérisé**
**en ce que** l'élément (5) de couplage est formé d'un transistor de commutation, constitué de manière intégrée monolithiquement dans le circuit à semi-conducteurs.
